# EUROPEAN PATENT SPECIFICATION

(11) **EP 3 393 970 B1**
(45) Date of publication and mention of the grant of the patent: **08.05.2024**
(21) Application number: 16813072.2
(22) Date of filing: 19.12.2016
(51) Int. Cl.: C01B 32/28, C30B 29/04, C30B 29/60, C30B 30/00, G01N 33/58, C30B 33/04

(54) **FLUORESCENT DIAMOND PARTICLES AND METHODS OF FABRICATING THE SAME**
FLUORESZIERENDE DIAMANTPARTIKEL UND VERFAHREN ZUR HERSTELLUNG DAVON
PARTICULES DE DIAMANT FLUORESCENTES ET LEURS PROCÉDÉS DE FABRICATION

(30) Priority: 21.12.2015 GB 201522512
(43) Date of publication of application: 31.10.2018
(73) Proprietor: Element Six (UK) Limited, Didcot, Oxfordshire OX11 0QR (GB)
(72) Inventor: MUNDAY, Mark Gregory, Didcot Oxfordshire OX11 0QR (GB); HALL, Jacqueline, Didcot Oxfordshire OX11 0QR (GB)
(74) Representative: Brack, Paul
(86) International application number: PCT/EP2016/081654
(87) International publication number: WO 2017/108655

(56) References cited:
- WO-A1-2010/102977
- WO-A1-2010/149775
- CHUANYI ZANG ET AL: "Growth and characterization of large, high quality cubic diamond crystals", CHINESE SCIENCE BULLETIN, SCIENCE IN CHINA PRESS, BE, vol. 57, no. 14, 8 March 2012 (2012-03-08) , pages 1733-1738, XP035045516, ISSN: 1861-9541, DOI: 10.1007/S11434-012-5023-4
- JEAN-PAUL BOUDOU ET AL: "High yield fabrication of fluorescent nanodiamonds", NANOTECHNOLOGY, IOP, BRISTOL, GB, vol. 20, no. 23, 10 June 2009 (2009-06-10) , page 235602, XP020160565, ISSN: 0957-4484
- SHAMES A I ET AL: "Magnetic resonance tracking of fluorescent nanodiamond fabrication", JOURNAL OF PHYSICS D: APPLIED PHYSICS, INSTITUTE OF PHYSICS PUBLISHING LTD, GB, vol. 48, no. 15, 25 March 2015 (2015-03-25), page 155302, XP020282656, ISSN: 0022-3727, DOI: 10.1088/0022-3727/48/15/155302 [retrieved on 2015-03-25]
- WANG KAIYUE ET AL: "Photoluminescence studies of growth-sector dependence of nitrogen distribution in synthetic Ib diamond", MATERIALS CHARACTERIZATION, vol. 94, 5 May 2014 (2014-05-05), pages 14-18, XP028870671, ISSN: 1044-5803, DOI: 10.1016/J.MATCHAR.2014.04.010

## Description

### Field of the Invention

The present invention relates to fluorescent diamond particles and methods of fabricating such particles for use in applications such as fluorescent markers and labels in biological applications and medical diagnostics.

### Background

Many point defects have been studied in synthetic diamond material including: silicon containing defects such as silicon-vacancy defects (Si-V), silicon di-vacancy defects (Si-V₂), silicon-vacancy-hydrogen defects (Si-V:H), silicon di-vacancy hydrogen defects (S-V₂:H); nickel containing defect; chromium containing defects; and nitrogen containing defects such as nitrogen-vacancy defects (N-V), di-nitrogen vacancy defects (N-V-N), and nitrogen-vacancy-hydrogen defects (N-V-H). These defects are typically found in a neutral charge state or in a negative charge state.

Fluorescent point defects in synthetic diamond material have been proposed for use in various sensing, detecting, and quantum processing applications including: magnetometers; spin resonance devices such as nuclear magnetic resonance (NMR) and electron spin resonance (ESR) devices; spin resonance imaging devices for magnetic resonance imaging (MRI); and quantum information processing devices such as for quantum computing.

In addition to the above, it has also been proposed to use fluorescent point defects in diamond material as fluorescent markers or labels in biological applications and medical diagnostics. For example, Rabeau et al. (Nano Letters, vol. 7, No. 11, 3433-3437, 2007) disclose the use of nanodiamonds as fluorescent labels in biological systems. As indicated by Rabeau et al, key advantages of nanodiamonds compared to other conventional fluorescent biolabels include their non-cytotoxicity, roomtemperature photostability, and the relative ease with which surfaces can be functionalized. It is further indicated that biological applications demand bright fluorescence from small crystals. In this regard, Rabeau et al. have performed an analysis of diamond particle size versus nitrogen-vacancy (NV) centre content and found a strong dependence of NV centre content and crystal size for diamond nano-crystals grown via a chemical vapour deposition technique. They report that a particle size of 60-70 nm is optimal for single NV centre incorporation per diamond nano-particle.

A problem with the diamond nano-particles described by Rabeau is that they have a low NV centre content and thus have a relatively low fluorescent intensity which is not ideal for many fluorescent marker applications. The Rabeau et al. document itself indicates that biological applications demand bright fluorescence from small crystals. However, there is no indication of how to incorporate a high concentration of NV centres into small diamond nano-crystals to increase their fluorescent intensity. The diamond nano-crystals described in the Rabeau et al. document have a low NV centre content and thus will have a relatively low fluorescent intensity not suited to many fluorescent marker applications.

US2014/0065424 discloses a method of producing light-emitting nano-particles of diamond. In the method described in this document, micron scale diamond particles are irradiated and annealed and then the particles are ground to nano-particles having a size between 15 and 20 nanometres.

A further problem is that the NV content is not uniform throughout all micron scale diamond particles in a powder after irradiation and annealing. This means that amplitude of the fluorescence (or brightness) will vary from particle to particle. A measurement of the amplitude of fluorescence of a large number of particles (perhaps in biological tissue) will not necessarily indicate the number of diamond particles present, as individual diamond particles will display a different fluorescent response.

WO 2010/102977 A1 discloses a method for manufacturing cubic diamond nanocrystals comprising steps of milling a crystalline micron diamond powder using micron jet milling micronization so as to manufacture a fine powder, and nanomilling said fine powder using a planetary tungsten carbide ball mill.

Zang et al. (Growth and characterization of large, high quality cubic diamond crystals, Chinese Science Bulletin, Science in China Press, BE, vol. 57, no. 14, 8 March 2012, pages 1733-1738, DOI: 10.1007/S11434-012-5023-4) discloses a temperature gradient method for growing high quality cubic diamond crystals.

### Summary

It is an object to provide a powder of fluorescent diamond particles in which the brightness of the fluorescence of individual diamond particle has a high degree of uniformity.

According to a first aspect, there is provided a diamond powder comprising diamond particles having an average particle size of no more than 20 µm and a vacancy or impurity-vacancy point defect concentration of at least 1 ppm. At least 70% of the volume of diamond in the powder is formed from a single crystal growth sector. This leads to a substantially uniform concentration of vacancies or impurity-vacancy point defects in the diamond particles because the rate of impurity take-up during growth is heavily dependent on the growth sector. One advantage of having a substantially uniform concentration of vacancies or impurity-vacancy point defects in the diamond particles is that a fluorescence response of the particles will be substantially the same.

Examples of suitable growth sectors include a {100} growth sector and a {111} growth sector.

As an option, the diamond particles are crushed from larger precursor diamond particles.

The vacancy or impurity-vacancy point defect concentration in the diamond particles is optionally is selected from any one of at least: 5 ppm; 10 ppm; 20 ppm; 50 ppm; or 100 ppm.

The impurity-vacancy point defects are optionally selected from any of nitrogen-vacancy point defects and silicon-vacancy point defects.

As an option, the particles in the powder have an average vacancy or impurity-vacancy point defect concentration, and a variation about the average vacancy or impurity-vacancy point defect concentration is selected from any one of no more than: 50%; 40%; 30%; 20% or 10%.

The average particle size of the diamond particles is optionally selected from any of no more than 1 µm, no more than 500 nm and no more than 200 nm. Smaller particle sizes may be useful in biological applications.

The diamond powder optionally comprises one or more organic functional groups bonded to an outer surface of the diamond particles.

As an option, the volume of diamond in the powder formed from a single crystal growth sector is selected from any of greater than 80% and greater than 90%. The higher the volume percentage, the more uniform the vacancy or impurity-vacancy point defect concentration is likely to be.

According to a second aspect, there is provided a precursor diamond powder comprising diamond particles having an average particle size of no more than 1 mm and a vacancy or impurity-vacancy point defect concentration of at least 1 ppm, wherein at least 70% of the volume of diamond in the powder is formed from a single crystal growth sector. Such a powder can, if required, be crushed to smaller sizes.

As an option, the volume of diamond in the precursor diamond powder formed from a single crystal growth sector is selected from any of greater than 80% and greater than 90%.

According to a third aspect, there is provided a method of fabricating a diamond powder comprising diamond particles having an average particle size of no more than 20µm. A precursor diamond powder is crushed to form a diamond powder with an average particle size of no more than 20 µm. The diamond powder comprises diamond particles having a vacancy or impurity-vacancy point defect concentration of at least 1 ppm, wherein at least 70% of the volume of diamond in the crushed diamond powder is formed from a single crystal growth sector.

As an option, the growth sector is selected from one of a {100} growth sector and a {111} growth sector.

In an optional embodiment, precursor diamond particles are irradiated, prior to crushing, to generate vacancy defects in the precursor diamond particles.

In an alternative optional embodiment, precursor diamond particles are irradiated after crushing, to generate vacancy defects in the precursor diamond particles.

The precursor diamond particles optionally have a nitrogen or silicon concentration selected from any one of at least: 10 ppm; 20 ppm; 50 ppm; 100 ppm; or 200 ppm.

As an option, the irradiating is performed at a temperature selected from any one of no more than: 500°C; 400°C; 300°C; 200°C; 100°C; or 50°C.

As an option, the irradiating step is controlled to introduce isolated vacancy point defects into the initial diamond particles at a concentration selected from any one of at least: 5 ppm; 10 ppm; 20 ppm; 50 ppm; 100 ppm; or 200 ppm.

As an option, the method comprises, after irradiating, annealing the diamond particles.

Annealing is optionally performed at a temperature selected from any one of at least: 600°C; 700°C; or 750°C. The annealing step is optionally performed at a temperature selected from any one of no more than: 1000°C; 900°C; 850°C; or 800°C.

As an option, after the irradiating and annealing steps the diamond particles have an impurity-vacancy point defect concentration selected from any one of at least: 5 ppm; 10 ppm; 20 ppm; 50 ppm; or 100 ppm. As a further option, the impurity-vacancy point defects are nitrogen-vacancy point defects or silicon-vacancy point defects.

As a further option, the method further comprises, prior to crushing the precursor diamond powder to form the diamond powder with an average particle size of no more than 20µm, sorting the precursor diamond powder to select diamond particles formed from substantially a single crystal growth sector.

As an option, the volume of diamond in the powder formed from a single crystal growth sector is selected from any of greater than 80% and greater than 90%. The higher the volume percentage, the more uniform the vacancy or impurity-vacancy point defect concentration is likely to be.

### Brief description of the drawings

For a better understanding of the present invention and to show how the same may be carried into effect, embodiments of the present invention will now be described by way of example only with reference to the accompanying drawings, in which:
Figure 1 illustrates schematically growth of a diamond particle from a diamond seed;
Figure 2 is a micrograph of exemplary precursor particles having a predominantly {100} growth sector;
Figure 3 is a micrograph of exemplary precursor particles having a predominantly {111} growth sector;
Figure 4 is a flow diagram showing exemplary steps for obtaining a diamond powder;
Figure 5 is a flow diagram showing alternative exemplary steps for obtaining a diamond powder; and
Figure 6 is a flow diagram showing exemplary steps for obtaining an irradiated diamond powder.

### Detailed description

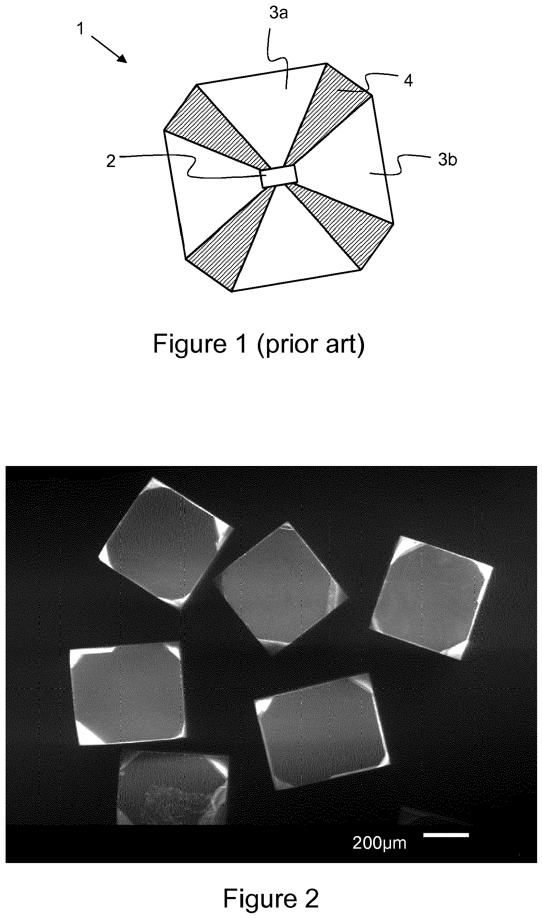

Figure 1 illustrates schematically a diamond particle 1 grown from a seed diamond particle 2 in a high-pressure high temperature (HPHT) process. The diamond particle has different crystallographic growth sectors. In the example of Figure 1, the diamond particle 1 has {100} growth sectors 3a, 3b and {111} growth sectors 4. It will be appreciated that other growth sectors, such as {113} and {115} also occur.

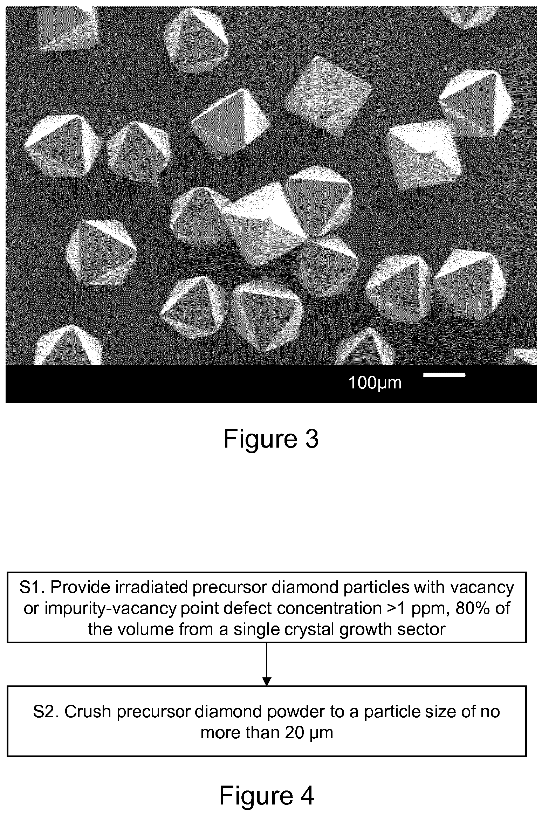

By careful control of the temperature and pressure during the HPHT process, desired growth sectors can be achieved at the expense of others. For example, conditions can be provided that favours the growth of {100} growth sectors, which means that after a certain amount of time the volume of a diamond crystal will almost entirely consist of {100} growth sectors. Figure 2 is a micrograph showing diamond particles in which each diamond particle has a volume consisting substantially of {100} growth sectors, and so forms a cubic shape. Figure 3 is a micrograph showing diamond particles in which each diamond particle has a volume consisting substantially of {111} growth sectors, and so forms an octahedral shape. In a typical HPHT process the control of the growth sectors is not so important and so diamond grits typically consist of particles having a cubic shape, an octahedral shape, and predominantly various intermediate cuboctahedral shapes. For the purposes of this disclosure, we are concerned with diamond powders comprising particles having substantially a single growth sector. Such powders may be obtained by careful control of pressure and temperature during synthesis, as described above, or by sorting diamond powders consisting of particles having a range of shapes. For example, sorting powders may be performed manually to select only predominantly cubic particles that consist substantially of {100} growth sectors.

Note also that synthetic diamond powders may be obtained by process other than HPHT, such as chemical vapour deposition (CVD).

During HPHT synthesis of diamond particles, nitrogen is typically present in the diamond lattice as an impurity. It is known that nitrogen is incorporated into the lattice with different concentrations depending on the orientation of growth surfaces, as described in Kanda, "Nonuniform distributions of color and luminescence of single crystal diamonds", New Diamond and Frontier Carbon Technology, 105-116 Vol. 17, No. 2, 2007. For example, the nitrogen impurity concentration in the {100} growth sectors of a diamond particle is typically around three times higher than the nitrogen impurity concentration in the {111} growth sectors of the same diamond particle. However, for a given batch of synthetic diamond particles, the nitrogen impurity concentration for a given growth sector will be substantially uniform for all particle volumes having that growth sector. Note that other factors can affect the uptake of impurities, such as the rate of growth of a growth sector, the concentration of the impurity in the solvent, and the temperature. However, to a certain extent these factors can be controlled to make the rate of nitrogen uptake predominantly dependent upon the growth sector.

It therefore follows that where diamond particles are obtained by crushing a standard diamond precursor powder that contains a mixture of cubic, octahedral and cuboctahedral particles, the resultant powders will have a range of different growth sectors and therefore a range of different nitrogen contents. In order to obtain diamond powders, some of the nitrogen impurities must be converted to nitrogen vacancies.

In addition to well-formed cubic, octahedral or cuboctahedral particles, a typical distribution of high-pressure high-temperature synthesised diamond also contains a proportion of irregular, granular or fragmentary particles. These may contain levels of nitrogen significantly different from that of the previously described well-formed particles (often lower, as they may grow in regions of a synthesis volume that are depleted of N). These particles must also be eliminated from the mixture of particles comprising the powder that is to be crushed to form the desired uniformly fluorescent product. Techniques well-known in the art, including sieving, magnetic separation or shape separation using vibrating tables may be used to remove these poorly shaped particles.

It is known that nitrogen vacancy (NV) centre concentration can be increased by irradiating and annealing nitrogen-containing diamond material. Irradiating diamond material, e.g. with electrons or neutrons, introduces vacancy defects into the diamond lattice by knocking carbon atoms off their lattice sites. If the diamond material is then annealed, e.g. at a temperature around 800°C, the vacancies migrate through the diamond lattice and pair up with single substitutional nitrogen defects to form NV centres.

The following description refers to precursor diamond particles, diamond particles and intermediate diamond particles. These terms are used for the purpose of describing examples only, and 'precursor does not necessarily mean that there were no previous processing steps involved in obtaining the precursor diamond particles. Precursor diamond particles are the particles obtained from initial synthesis (e.g. HPHT or CVD). Where irradiation is performed before crushing, intermediate diamond particles are obtained by irradiating and optionally annealing the precursor diamond particles to increase the NV centre concentration. Diamond particles are obtained by crushing precursor diamond particles to the required size (either before or after irradiation).

A problem is that irradiation introduces a lot of energy into diamond particles, and can graphitize nano-scale diamond particles for use a bio-markers. One solution to this problem is to irradiate larger diamond particles on a cooling block, anneal the irradiated diamond particles to form a high concentration of NV centres, and then crush the diamond particles to reduce their size in order to form a diamond nano-powder with a high NV content. Such a fabrication method is described in US2014/0065424 discussed in the background section of this specification. This fabrication route is viable but not optimal. The reason why this fabrication route is not optimal is that many applications require diamond particles which lie within a relatively tight particle size distribution and/or a relatively uniform fluorescent intensity. However, a crushing process performed after irradiation and annealing will yield a relatively large particle size distribution and also a relatively large variation in fluorescent intensity because the particles have different or multiple growth sectors.

A solution would be to ensure that the diamond powder has the desired particle size distribution prior to subjecting the material to irradiation and annealing such that the treated material does not require further crushing and particle size-filtering steps. However, as previously indicated, irradiation of diamond nano-particles with a sufficient dosage of irradiation to form very bright, high NV content diamond nano-particles can cause thermal management issues such as graphitization of the diamond nano-particles and/or annealing out of vacancies during the irradiation treatment. Furthermore, handling loose diamond nano-powder during irradiation and annealing treatments can be difficult and hazardous and also subject to problems of achieving uniformity.

It has been appreciated that crushing a precursor diamond powder formed from diamonds having substantially a single growth sector will ensure that the resultant diamond powders have a substantially uniform NV concentration after irradiation. To achieve the maximum fluorescence it is preferred to use the {100} growth sectors, but it will be appreciated that using precursor diamond particles predominantly having {111} growth sectors will also give rise to a uniform distribution of NV centres after irradiation.

By ensuring that at least 70% of the volume of a precursor diamond powder is from a single growth sector, on average each irradiated and crushed diamond particle will produce substantially the same amount of fluorescence. This leads to a very tight distribution of fluorescence amplitude.

Figure 4 is a flow diagram illustrated exemplary steps to obtaining fluorescent diamond particles. The following numbering corresponds to that of Figure 4:
S1. A precursor diamond powder is provided. The precursor diamond powder is irradiated to form intermediate diamond particles having a vacancy or impurity-vacancy point defect concentration of at least 1 ppm and an average particle size of up to 1 mm. At least 70% of the volume of diamond in the precursor diamond powder is formed from a single crystal growth sector, such as {100}.
S2. The intermediate diamond particles are crushed to an average particle size of no more than 20µm.

In the example of Figure 4, irradiation is performed prior to crushing. The crushed powders will inherit the same single growth sector as the precursor powder. A problem with irradiating prior to crushing is that some crushed particles may be discarded, for example if it is not the correct size. In this case, it was unnecessary to irradiate the discarded particles.

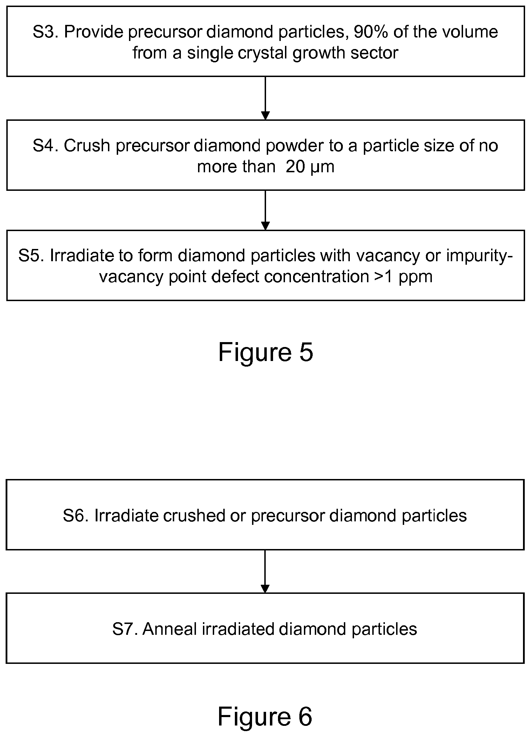

Figure 5 is a flow diagram showing alternative steps to those shown in Figure 4. The following numbering corresponds to that of Figure 5:
S3. A precursor diamond powder is provided. The precursor diamond powder has an average particle size of up to 1 mm. At least 70% of the volume of diamond in the precursor diamond powder is formed from a single crystal growth sector, such as {100}.
S4. The precursor diamond powder is crushed to an average particle size of no more than 20µm.
S5. The crushed diamond powder is irradiated to provide a crushed diamond powder having a vacancy or impurity-vacancy point defect concentration of at least 1 ppm.

A disadvantage of the method of Figure 5 is that the particle size is very small and the energy of irradiation can damage the diamond particles, for example by graphitization.

Diamond powders obtained by the processes shown in Figures 4 or 5 are suitable for use in applications such as fluorescent markers and labels in biological applications and medical diagnostics. Note that for many biological applications, it may be required to crush the precursor diamond particles to a size of 1µm or less.

Figure 6 is a flow diagram showing exemplary steps of irradiation. The following numbering corresponds to that of Figure 6:
S6. Crushed or precursor diamond particles are irradiated to generate vacancy defects in the diamond particles. Various techniques outside the scope of this disclosure may be used to mitigate the effects of applying a large amount of energy to small particles to reduce the risk of thermal damage and/or graphitization. The irradiating step may be controlled to introduce isolated vacancy point defects into the initial diamond particles at a concentration selected from any one of at least: 10 ppm; 20 ppm; 50 ppm; 100 ppm; or 200 ppm.
S7. After irradiation, the irradiated diamond particles may be annealed at a temperature suitable to cause migration of vacancy defects through the diamond lattice and formation of nitrogen-vacancy defects. This may be performed at a temperature selected from any one of at least: 600°C; 700°C; or 750°C. The annealing temperature may be selected from any one of no more than: 1000°C; 900°C; 850°C; or 800°C. The annealing step may be performed under vacuum or under an inert atmosphere to prevent graphitization of the diamond material during the annealing process.

After steps S6 and S7, the precursor diamond particles may have an impurity-vacancy point defect concentration selected from any one of at least: 5 ppm; 10 ppm; 20 ppm; 50 ppm; or 100 ppm. The impurity-vacancy point defect concentration may be selected from any one of no more than: 500 ppm; 400 ppm; 300; or 200 ppm.

Note that annealing step S7 may be performed immediately after irradiation step S6, or in the case where precursor diamond particles are irradiated, the annealing step may be carried out before or after subsequent crushing.

If it is required to achieve highly fluorescent diamond particles having a high nitrogen-vacancy content, the initial diamond particles should be selected to have a high nitrogen content. For example, the initial diamond particles may have a nitrogen concentration of between at least 10 ppm and 500ppm, as described above.

Furthermore, to achieve highly fluorescent diamond particles having a high nitrogen-vacancy content, the irradiation step should be controlled to introduce a large concentration of isolated vacancy point defects into the diamond material. For example, the irradiating step may be controlled to introduce isolated vacancy point defects into the diamond particles at a concentration of at least 10 ppm and/or a concentration of no more than 500 ppm as described above.

The irradiation may be via electrons, neutrons, ion bombardment; or gamma rays with electron irradiation being preferred for certain applications. In addition, the use of a heat sink on which the diamond body is placed allows the temperature to be controlled. For example, the irradiating may be performed at a temperature of no more than 500°C, 400°C, 300°C, 200°C, 100°C, or 50°C. The initial diamond powder may be merely placed on the heat sink. Alternatively, a thermal contact fluid, paste, or bonding may be used to control the thermal contact between the initial diamond powder and the underlying heat sink.

While the methodology has been described above in relation to the formation of fluorescent nitrogen-vacancy point defects, it is also envisaged that the fluorescent defects may be formed by the vacancy defects themselves or by other impurity-vacancy defects such as silicon-vacancy defects. Where vacancy defects are utilized as the active functional defect, no annealing step is required after irradiation. For other impurity-vacancy defects such as silicon-vacancy defects an irradiation treatment followed by an annealing treatment can be applied in a similar manner to the nitrogen-vacancy based fluorescent diamond particles as described previously.

The above description refers to average particle size. There are many ways in which particle size may be measured. For example a size range of particles may be expressed in terms of U.S. Mesh size, in which two mesh sizes are provided, the first being a mesh size through which the grains would pass and the second being a mesh size through which the grains would not pass. Mesh size may be expressed in terms of the number of openings per (linear) unit length of mesh. For smaller particle size (say, less than 20 µm), the particle size can be expressed in terms of equivalent circle diameter (ECD), in which each particle is regarded as though it were a sphere. The ECD distribution of a plurality of particles can be measured by means of laser diffraction, in which the particles are disposed randomly in the path of incident light and the diffraction pattern arising from the diffraction of the light by the particles is measured. The diffraction pattern may be interpreted mathematically as if it had been generated by a plurality of spherical particles, the diameter distribution of which being calculated and reported in terms of ECD. Aspects of a particle size distribution may be expressed in terms of various statistical properties using various terms and symbols. Particular examples of such terms include mean, median and mode. The size distribution can be thought of as a set of values *Di* corresponding to a series of respective size channels, in which each *Di* is the geometric mean ECD value corresponding to respective channel *i*, being an integer in the range from 1 to the number *n* of channels used.

## Claims

1. A diamond powder comprising diamond particles having an average particle size of no more than 20 µm and a vacancy or impurity-vacancy point defect concentration of at least 1 ppm, wherein at least 70% of the volume of diamond in the powder is formed from a single crystal growth sector.

2. The diamond powder according to claim 1, wherein:
the growth sector is selected from one of a {100} growth sector and a {111} growth sector; and/or
the vacancy or impurity-vacancy point defect concentration is selected from any one of at least: 5 ppm; 10 ppm; 20 ppm; 50 ppm; or 100 ppm; and/or
the impurity-vacancy point defects are selected from any of nitrogen-vacancy point defects and silicon-vacancy point defects; and/or
the particles in the powder have an average vacancy or impurity-vacancy point defect concentration, and a variation about the average vacancy or impurity-vacancy point defect concentration is selected from any one of no more than: 50%; 40%; 30%; 20% or 10%; and/or
the average particle size of the diamond particles is selected from any of no more than 500 nanometres and no more than 200 nanometres; and/or
further comprising one or more organic functional groups bonded to an outer surface of the diamond particles.

3. The diamond powder according to any one of claims 1 or 2, wherein the volume of diamond in the powder formed from a single crystal growth sector is selected from any of greater than 80% and greater than 90%.

4. A precursor diamond powder comprising diamond particles having an average particle size of no more than 1 mm and a vacancy or impurity-vacancy point defect concentration of at least 1 ppm, wherein at least 70% of the volume of diamond in the powder is formed from a single crystal growth sector.

5. The precursor diamond powder according to claim 4, wherein the volume of diamond in the powder formed from a single crystal growth sector is selected from any of greater than 80% and greater than 90%.

6. A method of fabricating a diamond powder comprising diamond particles having an average particle size of no more than 20 µm, the method comprising:
crushing a precursor diamond powder to form a diamond powder with an average particle size of no more than 20µm, the diamond powder comprising diamond particles having a vacancy or impurity-vacancy point defect concentration of at least 1 ppm, wherein at least 70% of the volume of diamond in the crushed diamond powder is formed from a single crystal growth sector.

7. The method according to claim 6, wherein the growth sector is selected from one of a {100} growth sector and a {111} growth sector.

8. The method according to claim 6 or 7, further comprising:
prior to crushing, irradiating precursor diamond particles to generate vacancy defects in the precursor diamond particles; or
subsequent to crushing, irradiating the diamond particles to generate vacancy defects in the diamond particles.

9. The method according to claim 8, wherein the precursor diamond particles have a nitrogen or silicon concentration selected from any one of at least: 10 ppm; 20 ppm; 50 ppm; 100 ppm; or 200 ppm.

10. The method according to any one of claims 8 or 9, wherein the irradiating step is:
performed at a temperature selected from any one of no more than: 500°C; 400°C; 300°C; 200°C; 100°C; or 50°C; and/or
controlled to introduce isolated vacancy point defects into the initial diamond particles at a concentration selected from any one of at least: 5 ppm; 10 ppm; 20 ppm; 50 ppm; 100 ppm; or 200 ppm.

11. The method according to any one of claims 8 to 10, further comprising, after irradiating, annealing the diamond particles.

12. The method according to claim 11, further comprising annealing at a temperature selected from any one of at least: 600°C; 700°C; or 750°C; and/or
the annealing step is performed at a temperature selected from any one of no more than: 1000°C; 900°C; 850°C; or 800°.

13. The method according to any one of claims 11 or 12, wherein after the irradiating and annealing steps the diamond particles have an impurity-vacancy point defect concentration selected from any one of at least: 5 ppm; 10 ppm; 20 ppm; 50 ppm; or 100 ppm.

14. The method according to claim 13, wherein the impurity-vacancy point defects are nitrogen-vacancy point defects or silicon-vacancy point defects.

15. The method according to any one of claims 6 to 14, further comprising, prior to crushing the precursor diamond powder to form the diamond powder with an average particle size of no more than 20µm, sorting the precursor diamond powder to select diamond particles formed from substantially a single crystal growth sector; and/or
the volume of diamond in the powder formed from a single crystal growth sector is selected from any of greater than 80% and greater than 90%.

## Patentansprüche

1. Diamantpulver, das Diamantpartikel mit einer durchschnittlichen Partikelgröße von nicht mehr als 20 µm und einer Leerstellen- oder Verunreinigungs-Leerstellenpunktdefektkonzentration von mindestens 1 ppm umfasst, wobei mindestens 70 % des Volumens des Diamanten in dem Pulver aus einem Einkristallzüchtungssektor gebildet sind.

2. Diamantpulver nach Anspruch 1, bei dem
der Züchtungssektor aus einem von einem {100} Züchtungssektor und einem {111} Züchtungssektor ausgewählt ist, und/oder
die Leerstellen- oder Verunreinigungs-Leerstellenpunktdefektkonzentration ausgewählt ist aus einer von mindestens 5 ppm, 10 ppm, 20 ppm, 50 ppm oder 100 ppm und/oder
die Verunreinigungs-Leerstellenpunktdefekte ausgewählt sind aus beliebigen von Stickstoff-Leerstellenpunktdefekten und Silicium-Leerstellenpunktdefekten und/oder
die Partikel in dem Pulver eine durchschnittliche Leerstellen- oder Verunreinigungs-Leerstellenpunktdefektkonzentration aufweisen, und eine Variation um die durchschnittliche Leerstellen- oder Verunreinigungs-Leerstellenpunktdefektkonzentration ausgewählt ist aus beliebigen von nicht mehr als 50 %, 40 %, 30 %, 20 % oder 10 % und/oder
die durchschnittliche Partikelgröße der Diamantpartikel ausgewählt ist aus beliebigen von nicht mehr als 500 Nanometern und nicht mehr als 200 Nanometern, und/oder
das des Weiteren eine oder mehrere organische funktionelle Gruppen umfasst, die an eine Außenoberfläche der Diamantpartikel gebunden sind.

3. Diamantpulver nach einem der Ansprüche 1 oder 2, bei dem das Volumen des Diamanten in dem Pulver, das aus einem Einkristallzüchtungssektor gebildet ist, ausgewählt ist aus beliebigen von größer als 80 % und größer als 90 %.

4. Vorläuferdiamantpulver, das Diamantpartikel mit einer durchschnittlichen Partikelgröße von nicht mehr als 1 mm und einer Leerstellen- oder Verunreinigungs-Leerstellenpunktdefektkonzentration von mindestens 1 ppm umfasst, wobei mindestens 70 % des Volumens des Diamanten in dem Pulver aus einem Einkristallzüchtungssektor gebildet sind.

5. Vorläuferdiamantpulver nach Anspruch 4, bei dem das Volumen des Diamanten in dem Pulver, das aus einem Einkristallzüchtungssektor gebildet ist, ausgewählt ist aus beliebigen von größer als 80 % und größer als 90 %.

6. Verfahren zur Fertigung von Diamantpulver, das Diamantpartikel mit einer durchschnittlichen Partikelgröße von nicht mehr als 20 µm umfasst, bei dem
Vorläuferdiamantpulver zerkleinert wird, um Diamantpulver mit einer durchschnittlichen Partikelgröße von nicht mehr als 20 µm zu bilden, wobei das Diamantpulver Diamantpartikel mit einer Leerstellen- oder Verunreinigungs-Leerstellenpunktdefektkonzentration von mindestens 1 ppm umfasst, wobei mindestens 70 % des Volumens des Diamanten in dem zerkleinerten Diamantpulver aus einem Einkristallzüchtungssektor gebildet sind.

7. Verfahren nach Anspruch 6, bei dem der Züchtungssektor ausgewählt ist aus einem von {100} Züchtungssektor und einem {111} Züchtungssektor.

8. Verfahren nach Anspruch 6 oder 7, bei dem des Weiteren
vor dem Zerkleinern Vorläuferdiamantpartikel bestrahlt werden, um Leerstellendefekte in den Vorläuferdiamantpartikeln zu erzeugen, oder
nach dem Zerkleinern die Diamantpartikel bestrahlt werden, um Leerstellendefekte in den Diamantpartikeln zu erzeugen.

9. Verfahren nach Anspruch 8, bei dem die Vorläuferdiamantpartikel eine Stickstoff- oder Siliciumkonzentration ausgewählt aus beliebigen von mindestens 10 ppm, 20 ppm, 50 ppm, 100 ppm oder 200 ppm aufweisen.

10. Verfahren nach einem der Ansprüche 8 oder 9, bei dem der Bestrahlungsschritt
bei einer Temperatur durchgeführt wird, die ausgewählt ist aus beliebigen von nicht mehr als 500°C, 400°C, 300°C, 200°C, 100°C oder 50°C und/oder
gesteuert wird, um isolierte Leerstellenpunktdefekte in die anfänglichen Diamantpartikel in einer Konzentration einzubringen, die ausgewählt ist aus beliebigen von mindestens 5 ppm, 10 ppm, 20 ppm, 50 ppm, 100 ppm oder 200 ppm.

11. Verfahren nach einem der Ansprüche 8 bis 10, bei dem des Weiteren die Diamantpartikel nach dem Bestrahlen getempert werden.

12. Verfahren nach Anspruch 11, bei dem des Weiteren bei einer Temperatur getempert wird, die ausgewählt ist aus beliebigen von mindestens 600°C, 700°C oder 750°C und/oder
der Temperschritt bei einer Temperatur durchgeführt wird, die ausgewählt ist aus beliebigen von nicht mehr als 1000°C, 900°C, 850°C oder 800°.

13. Verfahren nach einem der Ansprüche 11 oder 12, bei dem die Diamantpartikel nach den Bestrahlungs- und Temperschritten eine Verunreinigungs-Leerstellenpunktdefektkonzentration aufweisen, die ausgewählt ist aus beliebigen von mindestens 5 ppm, 10 ppm, 20 ppm, 50 ppm oder 100 ppm.

14. Verfahren nach Anspruch 13, bei dem die Verunreinigungs-Leerstellenpunktdefekte Stickstoff-Leerstellenpunktdefekte oder Silicium-Leerstellenpunktdefekte sind.

15. Verfahren nach einem der Ansprüche 6 bis 14, bei dem des Weiteren vor dem Zerkleinern des Vorläuferdiamantpulvers, um das Diamantpulver mit einer durchschnittlichen Partikelgröße von nicht mehr als 20 µm zu bilden, das Vorläuferdiamantpulver sortiert wird, um Diamantpartikel auszuwählen, die aus im Wesentlichen einem Einkristallzüchtungssektor gebildet sind, und/oder
das Volumen des Diamanten in dem Pulver, das aus einem Einkristallzüchtungssektor gebildet ist, ausgewählt ist aus beliebigen von größer als 80 % und größer als 90 %.

## Revendications

1. Poudre de diamant comprenant des particules de diamant ayant une taille moyenne de particules non supérieure à 20 µm et une concentration en défauts ponctuels de type lacune ou lacune par impureté d'au moins 1 ppm, dans laquelle au moins 70 % du volume de diamant dans la poudre sont formés à partir d'un seul secteur de croissance cristalline.

2. Poudre de diamant selon la revendication 1, dans laquelle :
le secteur de croissance est choisi parmi l'un d'un secteur de croissance de {100] et d'un secteur de croissance de {111} ; et/ou
la concentration en défauts ponctuels de type lacune ou lacune par impureté est choisie parmi une quelconque valeur d'au moins : 5 ppm ; 10 ppm ; 20 ppm ; 50 ppm ; ou 100 ppm ; et/ou
les défauts ponctuels de type lacune par impureté sont choisis parmi n'importe lesquels de défauts ponctuels de lacune d'azote et de défauts ponctuels de lacune de silicium ; et/ou
les particules contenues dans la poudre présentent une concentration moyenne en défauts ponctuels de type lacune ou lacune par impureté, et une variation autour de la concentration moyenne en défauts ponctuels de type lacune ou lacune par impureté est choisie parmi une quelconque d'une valeur non supérieure à : 50 % ; 40 % ; 30 % ; 20 % ou 10 % ; et/ou
la taille moyenne de particules des particules de diamant est choisie parmi n'importe quelle valeur non supérieure à 500 nanomètres et non supérieure à 200 nanomètres ; et/ou
comprenant en outre un ou plusieurs groupe(s) fonctionnel(s) organique(s) lié(s) à une surface externe des particules de diamant.

3. Poudre de diamant selon l'une quelconque de la revendication 1 ou 2, dans laquelle le volume de diamant dans la poudre formée d'un seul secteur de croissance cristalline est choisi parmi n'importe quelle valeur supérieure à 80 % et supérieure à 90 %.

4. Poudre de diamant précurseur comprenant des particules de diamant ayant une taille moyenne de particules non supérieure à 1 mm et une concentration en défauts ponctuels de type lacune ou lacune par impureté d'au moins 1 ppm, dans laquelle au moins 70 % du volume de diamant dans la poudre sont formés à partir d'un seul secteur de croissance cristalline.

5. Poudre de diamant précurseur selon la revendication 4, dans laquelle le volume de diamant dans la poudre formée à partir d'un seul secteur de croissance cristalline est choisi parmi n'importe quelle valeur supérieure à 80 % et supérieure à 90 %.

6. Procédé de fabrication d'une poudre de diamant comprenant des particules de diamant ayant une taille moyenne de particules non supérieure à 20 µm, le procédé comprenant :
le concassage d'une poudre de diamant précurseur afin de former une poudre de diamant avec une taille moyenne de particules non supérieure à 20 µm, la poudre de diamant comprenant des particules de diamant qui présentent une concentration en défauts ponctuels de type lacune ou lacune par impureté d'au moins 1 ppm, dans lequel au moins 70 % du volume de diamant dans la poudre de diamant concassé sont formés à partir d'un seul secteur de croissance cristalline.

7. Procédé selon la revendication 6, dans lequel le secteur de croissance est choisi parmi l'un d'un secteur de croissance de {100} et d'un secteur de croissance de {111}.

8. Procédé selon la revendication 6 ou 7, comprenant en outre :
avant le concassage, l'irradiation des particules de diamant précurseur afin de générer des défauts de type lacune dans les particules de diamant précurseur ; ou
après le concassage, l'irradiation des particules de diamant afin de générer des défauts de type lacune dans les particules de diamant.

9. Procédé selon la revendication 8, dans lequel les particules de diamant précurseur présentent une concentration en azote ou en silicium choisie parmi une quelconque valeur d'au moins : 10 ppm ; 20 ppm ; 50 ppm ; 100 ppm ; ou 200 ppm.

10. Procédé selon l'une quelconque de la revendication 8 ou 9, dans lequel l'étape d'irradiation est :
effectuée à une température choisie parmi n'importe quelle valeur non supérieure à : 500°C ; 400°C ; 300°C ; 200°C ; 100°C ; ou 50°C ; et/ou
contrôlée afin d'introduire des défauts ponctuels isolés de type lacune dans les particules de diamant initiales à une concentration choisie parmi n'importe quelle valeur d'au moins 5 ppm ; 10 ppm ; 20 ppm ; 50 ppm ; 100 ppm ; ou 200 ppm.

11. Procédé selon l'une quelconque des revendications 8 à 10, comprenant en outre, après l'irradiation, le recuit des particules de diamant.

12. Procédé selon la revendication 11, comprenant en outre le recuit à une température choisie parmi n'importe quelle valeur d'au moins : 600°C ; 700°C ; ou 750°C ; et/ou
l'étape de recuit est effectuée à une température choisie parmi n'importe quelle valeur non supérieure à : 1000°C ; 900°C ; 850°C ; ou 800°.

13. Procédé selon l'une quelconque de la revendication 11 ou 12, dans lequel, après les étapes d'irradiation et de recuit, les particules de diamant présentent une concentration en défauts ponctuels de type lacune par impureté choisie parmi n'importe quelle valeur d'au moins : 5 ppm ; 10 ppm ; 20 ppm ; 50 ppm ; ou 100 ppm.

14. Procédé selon la revendication 13, dans lequel les défauts ponctuels de type lacune par impureté sont des défauts ponctuels de type lacune d'azote ou des défauts ponctuels de type lacune de silicium.

15. Procédé selon l'une quelconque des revendications 6 à 14, comprenant en outre, avant le concassage de la poudre de diamant précurseur afin de former la poudre de diamant avec une taille moyenne de particules non supérieure à 20 µm, le tri de la poudre de diamant précurseur afin de sélectionner des particules de diamant formées sensiblement à partir d'un seul secteur de croissance cristalline ;
et/ou
le volume de diamant dans la poudre formée à partir d'un seul secteur de croissance cristalline est choisi parmi n'importe quelle valeur supérieure à 80 % et supérieure à 90 %.
